# EUROPEAN PATENT APPLICATION

(11) **EP 4 615 183 A1**
(43) Date of publication of application: **10.09.2025**
(21) Application number: 25161579.5
(22) Date of filing: 04.03.2025
(51) Int. Cl.: H05K 7/20

(54) **POWER MODULE AND CHARGING DEVICE**

(30) Priority: 05.03.2024 CN 202410255098; 23.01.2025 CN 202510112505
(71) Applicant: Huawei Digital Power Technologies Co., Ltd., Futian District, Shenzhen, Guangdong 518043 (CN)
(72) Inventor: FAN, Guohua, Shenzhen, 518043 (CN); ZHANG, Zhidong, Shenzhen, 518043 (CN); WU, Chenglong, Shenzhen, 518043 (CN); YANG, Qiuguo, Shenzhen, 518043 (CN); LIU, Shaolong, Shenzhen, 518043 (CN)
(74) Representative: Epping - Hermann - Fischer

(57) **Abstract**

Embodiments of this application provide a power module and a charging device. The power module includes a bottom housing, a circuit board assembly fastened in the bottom housing, and a liquid cooling plate assembly fastened outside the bottom housing. The circuit board assembly includes a circuit board and a plurality of power devices, and the plurality of power devices are fastened to a surface of the circuit board. The liquid cooling plate assembly is located on a side that is of the plurality of power devices and that is away from the circuit board, and the liquid cooling plate assembly is configured to be thermally connected to the plurality of power devices through the bottom housing, to implement liquid cooling heat dissipation for the plurality of power devices. Further, in embodiments of this application, heat dissipation effect on the power device in the power module can be improved, and heat dissipation costs of the power module can be reduced, thereby meeting a heat dissipation requirement of the power device during high-power operation, and improving a service life and reliability of the power module during high-power operation.

## Description

This application claims priority to Chinese Patent Application No. 202410255098.9, filed with the China National Intellectual Property Administration on March 5, 2024 and entitled "POWER MODULE AND CHARGING DEVICE", which is incorporated herein by reference in its entirety.

### TECHNICAL FIELD

This application relates to the field of heat dissipation technologies for charging devices, and more specifically, to a power module and a charging device.

### BACKGROUND

Currently, with acceleration of the carbon peaking and carbon neutrality strategy and increasing popularity of electric vehicles, an increasing number of cities are developing into ultra-fast charging cities, so that the electric vehicles can be quickly replenished at a speed of one kilometer per second by using high-power ultra-fast charging devices, thereby creating a brand-new charging experience of "Charge Up While You Coffee Up".

However, when the charging device performs high-power ultra-fast charging on the electric vehicle, heat generated by a power device in the charging device increases significantly. If the heat cannot be discharged in time, normal high-power ultra-fast charging of the electric vehicle by the charging device is easily affected. However, a heat dissipation system in an existing charging device has poor heat dissipation effect on a power device, and costs of the heat dissipation system are high. Consequently, it is difficult to meet a heat dissipation requirement of the power device during high-power operation.

### SUMMARY

This application provides a power module and a charging device, to improve heat dissipation effect on a power device in the power module and reduce heat dissipation costs of the power module, thereby meeting a heat dissipation requirement of the power device during high-power operation, and improving a service life and reliability of the power module during high-power operation. This helps the charging device implement a charging speed of one kilometer per second, that is, charge an electric vehicle with electrical energy for one kilometer of driving in one second, thereby bringing charging experience of "Charge Up While You Coffee Up" to a user.

According to a first aspect, a power module is provided. The power module includes a bottom housing, a circuit board assembly, and a liquid cooling plate assembly. The circuit board assembly is fastened in the bottom housing, and the liquid cooling plate assembly is fastened outside the bottom housing. The circuit board assembly includes a circuit board and a plurality of power devices, and the plurality of power devices are fastened to a surface of the circuit board. The liquid cooling plate assembly is located on a side that is of the plurality of power devices and that is away from the circuit board, and the liquid cooling plate assembly is configured to be thermally connected to the plurality of power devices through the bottom housing.

In this embodiment of this application, the liquid cooling plate assembly fastened outside the bottom housing is thermally connected through the bottom housing to the circuit board assembly fastened in the bottom housing. A cooling medium in the liquid cooling plate assembly may exchange heat with the power device through the bottom housing, to implement liquid cooling heat dissipation for the power device. Compared with conventional air cooling heat dissipation, the liquid cooling heat dissipation has higher efficiency, and can implement good heat dissipation for the power device. Moreover, the bottom housing is used as an isolation structure between the liquid cooling plate assembly and the circuit board assembly, to implement water and electricity isolation between the liquid cooling plate assembly and the circuit board assembly, thereby avoiding impact of cooling medium leakage in the liquid cooling plate assembly on the circuit board assembly, and ensuring safety and stability of liquid cooling heat dissipation performed by the liquid cooling plate assembly on the power device. Further, this improves heat dissipation effect on the power device, and helps meet a heat dissipation requirement of the power device during high-power operation and improve a service life and reliability of the power module during high-power operation.

In this way, when the power module is used in the charging device, it helps the charging device implement a charging speed of one kilometer per second, thereby bringing charging experience of "Charge Up While You Coffee Up" to a user. In addition, the liquid cooling heat dissipation manner used by the power module also helps the charging device meet a construction requirement of a full-liquid cooling ultra-fast charging station, that is, helps meet a requirement that a power module and a charging connector of each charging device in the charging station use liquid cooling heat dissipation.

In addition to providing casing protection, the bottom housing of the power module is further configured to support and fasten the circuit board and implement water and electricity isolation between the liquid cooling plate assembly and the circuit board assembly, so that the power module implements an isolation structure for water and electricity isolation without separate disposing of a support structure for the circuit board assembly. In this way, a structure of a heat dissipation system including the bottom housing and the liquid cooling plate assembly is simplified, and use of parts and components in the power module is reduced, thereby reducing heat dissipation costs of the power module. In an implementation, the liquid cooling plate assembly includes a liquid cooling top plate and a liquid cooling bottom plate. The liquid cooling top plate and the liquid cooling bottom plate are sequentially arranged in a direction from the circuit board to the plurality of power devices. A surface that is of the liquid cooling top plate and that faces the circuit board is thermally connected to an outer surface of the bottom housing. A surface that is of the liquid cooling top plate and that is away from the circuit board is fastened to the liquid cooling bottom plate. A liquid cooling channel is formed between the liquid cooling top plate and the liquid cooling bottom plate, and the liquid cooling channel is configured to accommodate a cooling medium. To be specific, a position at which the liquid cooling top plate is fastened to the liquid cooling bottom plate to form the liquid cooling channel and a position at which the liquid cooling top plate is fastened to the bottom housing are both located outside the bottom housing, so that the bottom housing can isolate the cooling medium in the liquid cooling channel from the circuit board assembly in the bottom housing, implementing water and electricity isolation between the circuit board assembly and the liquid cooling plate assembly. In an implementation, the plurality of power devices include a first power device, a position that is on the liquid cooling top plate and that corresponds to the first power device is recessed toward the circuit board to form a groove structure. A groove bottom of the groove structure extends into the bottom housing and is thermally connected to one end that is of the first power device and that faces the liquid cooling top plate.

It should be understood that, because a height of the first power device in the plurality of power devices is relatively small, and a distance between the first power device and the bottom housing is relatively long, it is difficult for the liquid cooling top plate outside the bottom housing to be thermally connected to the first power device through the bottom housing. Therefore, in this embodiment of this application, the groove structure that is recessed toward the circuit board is disposed on the liquid cooling top plate, and the groove bottom of the groove structure extends into the bottom housing, so that the first power device can be directly thermally connected to the liquid cooling top plate. This not only can implement liquid cooling heat dissipation of the liquid cooling plate assembly for the first power device, but also can improve efficiency in transferring heat of the first power device to the cooling medium because the first power device is directly thermally connected to the liquid cooling top plate, thereby accelerating a heat dissipation process of the liquid cooling plate assembly for the first power device, and improving heat dissipation effect on the first power device.

In an implementation, the power module further includes a thermal conductor. The groove bottom of the groove structure is thermally connected through the thermal conductor to the end that is of the first power device and that faces the liquid cooling top plate.

In this embodiment of this application, the thermal conductor is disposed between the groove bottom of the groove structure and the first power device, so that the first power device can be in close contact with the groove bottom of the groove structure through the thermal conductor. In this way, the first power device has a relatively large contact area with the groove bottom of the groove structure. This helps improve efficiency in transferring heat of the first power device to the groove structure of the liquid cooling top plate, thereby accelerating a heat dissipation process of the liquid cooling plate assembly for the first power device, and improving heat dissipation effect on the first power device.

In an implementation, the liquid cooling plate assembly further includes a boss structure and turbulence fins. The boss structure is fastened to a surface that is of the liquid cooling bottom plate and that faces the circuit board, and extends toward the circuit board. The boss structure is disposed corresponding to the groove structure, and there is spacing between the boss structure and the groove structure to form a liquid cooling channel. The turbulence fins are located in the liquid cooling channel and are fastened to an end face that is of the boss structure and that faces the circuit board. In this embodiment of this application, the boss structure is disposed at a position that is on the liquid cooling bottom plate and that corresponds to the groove structure, to reduce a distance between the groove structure of the liquid cooling top plate and the liquid cooling bottom plate, thereby reducing a size of the liquid cooling channel formed at the groove structure. This helps improve a capability of the turbulence fins to repeatedly disturb the cooling medium in the liquid cooling channel at the groove structure, thereby enhancing local heat dissipation enhancement effect of the cooling medium formed at a position that is in the liquid cooling channel and that corresponds to the first power device, and improving heat dissipation efficiency of the liquid cooling plate assembly for the first power device.

In an implementation, the power module further includes a partition plate. The partition plate is located in the bottom housing, and the partition plate is configured to divide space in the bottom housing into a plurality of accommodating cavities. The plurality of power devices include a plurality of second power devices. The second power device is located in the accommodating cavity, and the second power device is thermally connected to an inner side wall of the accommodating cavity and the bottom housing. That is, the partition plate forms a side wall of the accommodating cavity, and the bottom housing forms a bottom of the accommodating cavity.

In this embodiment of this application, the second power device with a relatively large height in the plurality of power devices is disposed in the accommodating cavity, and the second power device is thermally connected to the inner side wall of the accommodating cavity and the bottom housing. In this way, heat of the second power device can not only be directly transferred to the liquid cooling top plate through the bottom housing, but also be first transferred to the bottom housing through the inner side wall of the accommodating cavity and then transferred to the liquid cooling top plate. This improves efficiency in transferring the heat of the second power device to the liquid cooling top plate, accelerates a heat dissipation process of the liquid cooling plate assembly for the second power device, and improves heat dissipation effect on the second power device.

In an implementation, the accommodating cavity accommodates a thermal conductive adhesive. The second power device is buried in the thermal conductive adhesive and is thermally connected to the inner side wall of the accommodating cavity and the bottom housing through the thermal conductive adhesive. In this way, the second power device can be in close contact with the bottom housing and the inner side wall of the accommodating cavity. This can improve efficiency in transferring the heat of the second power device to the liquid cooling top plate, thereby improving heat dissipation efficiency of the power module.

In an implementation, the bottom housing includes a bottom plate and a surrounding plate. The bottom plate is located between the circuit board and the liquid cooling top plate, and a surface that is of the bottom plate and that is away from the circuit board is thermally connected to the surface that is of the liquid cooling top plate and that faces the circuit board. The surrounding plate is fastened to a surface that is of the bottom plate and that faces the circuit board, and the surrounding plate and the bottom plate form the space through enclosing in the bottom housing. One end of the partition plate is fastened to the surface that is of the bottom plate and that faces the circuit board, the other end of the partition plate extends toward the circuit board, and the other end of the partition plate is not in contact with the circuit board. That is, there is a gap between the other end of the partition plate and the surface of the circuit board for arranging the power device. In this way, space on the surface of the circuit board can be prevented from being occupied due to contact between the other end of the partition plate and the surface of the circuit board, thereby facilitating arrangement of the plurality of power devices in the power module on the surface of the circuit board.

In an implementation, the power module further includes a fastener. One end of the fastener is fastened to the circuit board, and the other end of the fastener is fastened to the bottom plate. Projections of the fastener and the partition plate do not overlap in an arrangement direction of the circuit board and the plurality of power devices.

In this embodiment of this application, the circuit board assembly is fastened in the bottom housing by using the fastener. In other words, the bottom housing is also configured to support and fasten the circuit board assembly. In this way, in the power module, a support structure does not need to be separately disposed for the circuit board assembly. Further, a structure of the power module is simplified, and use of parts and components in the power module is reduced, thereby reducing costs of the power module.

In an implementation, the first power device includes a power switch transistor, and the plurality of second power devices include an inductor, a capacitor, and a transformer. The power switch transistor, the inductor, the capacitor, and the transformer are electrically connected by using the circuit board, to form an alternating current-direct current AC-DC conversion circuit or a direct current-direct current DC-DC conversion circuit. In other words, the power module provided in this embodiment of this application may be an AC-DC power module or a DC-DC power module. In an implementation, the liquid cooling plate assembly further includes a liquid inlet connector and a liquid outlet connector. The liquid inlet connector and the liquid outlet connector are fastened to the surface that is of the liquid cooling top plate and that faces the circuit board, and are separately connected to the liquid cooling channel. The liquid inlet connector allows the cooling medium to flow into the liquid cooling channel, and the liquid outlet connector allows the cooling medium in the liquid cooling channel to flow out of the liquid cooling channel.

In this embodiment of this application, after the cooling medium in the liquid cooling channel absorbs heat generated by the power device, the cooling medium that carries the heat may flow out of the liquid cooling channel through the liquid outlet connector, and then flow into an external cooling system, so that the external cooling system may cool the cooling medium that carries the heat, and the cooled cooling medium flows into the liquid cooling channel again through the liquid inlet connector. In this way, the cooling medium is cyclically used, so that the liquid cooling plate assembly continuously dissipates heat for the plurality of power devices.

In an implementation, the bottom housing, the liquid cooling top plate, and the liquid cooling bottom plate are all fabricated of a sheet metal material by using a stamping molding process, and the bottom housing is fastened to the liquid cooling top plate by welding.

In this embodiment of this application, the bottom housing, the liquid cooling top plate, and the liquid cooling bottom plate are fabricated of the sheet metal material by using the stamping molding process. The sheet metal material has relatively high thermal conductivity, and in comparison with a die-casting molding process, pores are not likely to be generated in the bottom housing, the liquid cooling bottom plate, and the liquid cooling top plate that are formed by stamping molding. This is conducive to making the bottom housing, the liquid cooling bottom plate, and the liquid cooling top plate achieve good thermal conductivity. In this way, heat generated by the plurality of power devices during operation can be quickly transferred through the bottom housing to the liquid cooling plate assembly outside the bottom housing, to implement liquid cooling heat dissipation for the circuit board assembly. Further, heat dissipation effect on the power module is improved.

Moreover, in comparison with the die-casting molding process, a die-casting die may not be used in the stamping molding process of the sheet metal material, so that the process is simpler and costs are lower. Therefore, in comparison with the die-casting molding process, the bottom housing 310 fabricated of the sheet metal material by using the stamping molding process better helps reduce processing difficulty of adjusting the structure of the bottom housing 310, and reduce processing costs.

In addition, a weld seam fastening the liquid cooling top plate to the bottom housing is located outside the bottom housing, so that the bottom housing can effectively isolate the circuit board assembly in the bottom housing from the liquid cooling channel outside the bottom housing, thereby implementing water and electricity isolation between the circuit board assembly and the liquid cooling assembly. In addition, in comparison with mechanical fastening performed between the liquid cooling top plate and the bottom housing by using a fastener such as a screw, in this embodiment of this application, the liquid cooling top plate and the bottom housing are fastened by welding, so that use of parts and components in the power module can be reduced, thereby reducing heat dissipation costs of the power module.

According to a second aspect, a charging device is provided. The charging device includes an alternating current-direct current AC-DC power module and at least one charging interface. The AC-DC power module is electrically connected to the at least one charging interface. The AC-DC power module is configured to convert an alternating current into a direct current and output the direct current to the at least one charging interface. The at least one charging interface is configured to provide the direct current for an electric vehicle. The AC-DC power module includes a circuit board assembly, a liquid cooling plate assembly, and a bottom housing. The circuit board assembly is disposed in the bottom housing, and the liquid cooling plate assembly is disposed outside the bottom housing. The circuit board assembly includes a circuit board and a plurality of power devices, and the plurality of power devices are fastened to a surface of the circuit board. The liquid cooling plate assembly is located on a side that is of the plurality of power devices and that is away from the circuit board, and the liquid cooling plate assembly is fastened to an outer surface of the bottom housing. The liquid cooling plate assembly is configured to be thermally connected to the plurality of power devices through the bottom housing.

According to a third aspect, a charging device is provided. The charging device includes an alternating current-direct current AC-DC power module, a direct current-direct current DC-DC power module, a direct current bus, and at least one charging interface. The AC-DC power module is connected to an input of the DC-DC power module by using the direct current bus. An output of the DC-DC power module is electrically connected to the at least one charging interface. The AC-DC power module is configured to convert an alternating current into a direct current and output the direct current to the direct current bus. The DC-DC power module is configured to perform power conversion on the direct current obtained from the direct current bus, and output a direct current obtained through power conversion to the at least one charging interface. The at least one charging interface is configured to provide an electric vehicle with the direct current obtained through power conversion. Each power module in the AC-DC power module and the DC-DC power module includes a circuit board assembly, a liquid cooling plate assembly, and a bottom housing. The circuit board assembly is disposed in the bottom housing, and the liquid cooling plate assembly is disposed outside the bottom housing. The circuit board assembly includes a circuit board and a plurality of power devices, and the plurality of power devices are fastened to a surface of the circuit board. The liquid cooling plate assembly is located on a side that is of the plurality of power devices and that is away from the circuit board, and the liquid cooling plate assembly is fastened to an outer surface of the bottom housing. The liquid cooling plate assembly is configured to be thermally connected to the plurality of power devices through the bottom housing.

For beneficial effects of the second aspect and the third aspect, refer to the beneficial effects of the first aspect. Details are not described herein again.

### BRIEF DESCRIPTION OF DRAWINGS

FIG. 1 is a diagram of a structure of a charging system according to an embodiment of this application;
FIG. 2 is a diagram of a connection structure of the charging system shown in FIG. 1;
FIG. 3 is a diagram of a three-dimensional structure of a power module according to an embodiment of this application;
FIG. 4 is a schematic exploded view of the power module shown in FIG. 3;
FIG. 5 is a diagram of an assembling structure of a circuit board assembly and a bottom housing in a power module according to an embodiment of this application;
FIG. 6 is a diagram of a structure of a bottom housing in a power module according to an embodiment of this application;
FIG. 7 is a diagram of a structure of a liquid cooling plate assembly in a power module according to an embodiment of this application;
FIG. 8 is a diagram of a structure of a liquid cooling top plate in the liquid cooling plate assembly shown in FIG. 7; and
FIG. 9 is a diagram of a structure of a liquid cooling bottom plate in the liquid cooling plate assembly shown in FIG. 7.

### DESCRIPTION OF EMBODIMENTS

For ease of understanding of embodiments of this application, the following descriptions are first provided before embodiments of this application are described.

In embodiments of this application, an orientation or a position relationship indicated by terms "upper", "lower", "left", "right", "front", "rear", "top", "bottom", "inside", "outside", or the like is an orientation or position relationship shown in the accompanying drawings, and is merely intended to facilitate description and simplify description of this application, but is not intended to indicate or imply that the mentioned apparatus or element needs to have a particular orientation or needs to be constructed and operated in a particular orientation. Therefore, such terms should not be understood as a limitation on this application.

In this application, "perpendicular" is not strictly perpendicular, but within an allowable error range. "Parallel" is not strictly parallel, but within an allowable error range.

In embodiments of this application, a same reference numeral indicates a same component part or a same part or component. In embodiments of this application, for a plurality of same parts or components, only one of the parts or components marked with a reference numeral may be used as an example in the figure. For another same part or component, reference numerals are also applicable. In addition, dimensions and sizes of the parts and components shown in the accompanying drawings are merely examples.

An embodiment of this application provides a power module. The power module includes a bottom housing, a circuit board assembly, and a liquid cooling plate assembly. The circuit board assembly is fastened in the bottom housing. The circuit board assembly includes a circuit board and a plurality of power devices, and the plurality of power devices are fastened to a surface of the circuit board. The liquid cooling plate assembly is fastened outside the bottom housing, and the liquid cooling plate assembly is located on a side that is of the plurality of power devices and that is away from the circuit board. The liquid cooling plate assembly is configured to be thermally connected to the plurality of power devices through the bottom housing.

In the power module provided in this embodiment of this application, the liquid cooling plate assembly fastened outside the bottom housing is thermally connected through the bottom housing to the circuit board assembly fastened in the bottom housing. A cooling medium in the liquid cooling plate assembly may exchange heat with the power device, to implement liquid cooling heat dissipation for the power device. Compared with conventional air cooling heat dissipation, the liquid cooling heat dissipation has higher efficiency, and can implement good heat dissipation for the power device. Moreover, the bottom housing may be used as an isolation structure between the liquid cooling plate assembly and the circuit board assembly, to implement water and electricity isolation between the liquid cooling plate assembly and the circuit board assembly, thereby avoiding impact of cooling medium leakage in the liquid cooling plate assembly on the circuit board assembly, and ensuring safety and stability of liquid cooling heat dissipation performed by the liquid cooling plate assembly on the power device. Further, this improves heat dissipation effect on the power device, and helps meet a heat dissipation requirement of the power device during high-power operation, and improves a service life and reliability of the power module during high-power operation.

In addition to providing casing protection, the bottom housing of the power module is further configured to support and fasten the circuit board and implement water and electricity isolation between the liquid cooling plate assembly and the circuit board assembly, so that the power module implements an isolation structure for water and electricity isolation without separate disposing of a support structure for the circuit board assembly. In this way, a structure of a heat dissipation system including the bottom housing and the liquid cooling plate assembly is simplified, and use of parts and components in the power module is reduced, thereby reducing heat dissipation costs of the power module. An embodiment of this application further provides a charging device. The charging device includes an alternating current-direct current (alternating current-direct current, AC-DC) power module and at least one charging interface. The AC-DC power module may be the power module described above. The AC-DC power module is electrically connected to the at least one charging interface, and the AC-DC power module is configured to convert an alternating current into a direct current and output the direct current to the at least one charging interface. The at least one charging interface is configured to provide the direct current for an electric vehicle, to charge the electric vehicle.

As described above, the AC-DC power module has good heat dissipation effect, and can meet a heat dissipation requirement of the AC-DC power module during high-power operation. This helps the charging device implement a charging speed of one kilometer per second, that is, charge the electric vehicle with electrical energy for one kilometer of driving in one second, thereby bringing charging experience of "Get fully charged at a speed of one kilometer per second" to a user. In addition, the liquid cooling heat dissipation manner used by the AC-DC power module also helps the charging device meet a construction requirement of a full-liquid cooling ultra-fast charging station, that is, helps meet a requirement that a power module and a charging connector of each charging device in the charging station use liquid cooling heat dissipation.

An embodiment of this application further provides a charging device. The charging device includes an AC-DC power module, a direct current-direct current (direct current-direct current, DC-DC) power module, a direct current bus, and at least one charging interface. The AC-DC power module and the DC-DC power module may be the power module described above. The AC-DC power module is connected to an input of the DC-DC power module by using the direct current bus, and an output of the DC-DC power module is electrically connected to the at least one charging interface. The AC-DC power module is configured to convert an alternating current into a direct current and output the direct current to the direct current bus. The DC-DC power module is configured to perform power conversion on the direct current obtained from the direct current bus, and output a direct current obtained through power conversion to the at least one charging interface. The at least one charging interface is configured to provide an electric vehicle with the direct current obtained through power conversion, to charge the electric vehicle.

As described above, the AC-DC power module and the DC-DC power module have good heat dissipation effect, and can meet heat dissipation requirements of the AC-DC power module and the DC-DC power module during high-power operation. This helps the charging device implement a charging speed of one kilometer per second, thereby bringing charging experience of "Get fully charged at a speed of one kilometer per second" to a user. In addition, the liquid cooling heat dissipation manner used by the AC-DC power module and the DC-DC power module also helps the charging device meet a construction requirement of a full-liquid cooling ultra-fast charging station, that is, helps meet a requirement that a power module and a charging connector of each charging device in the charging station use liquid cooling heat dissipation.

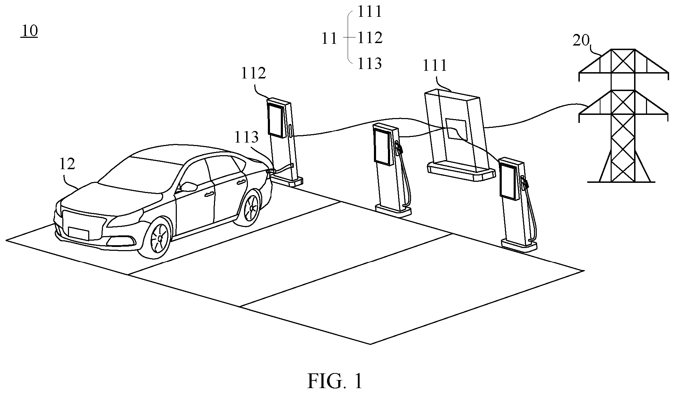

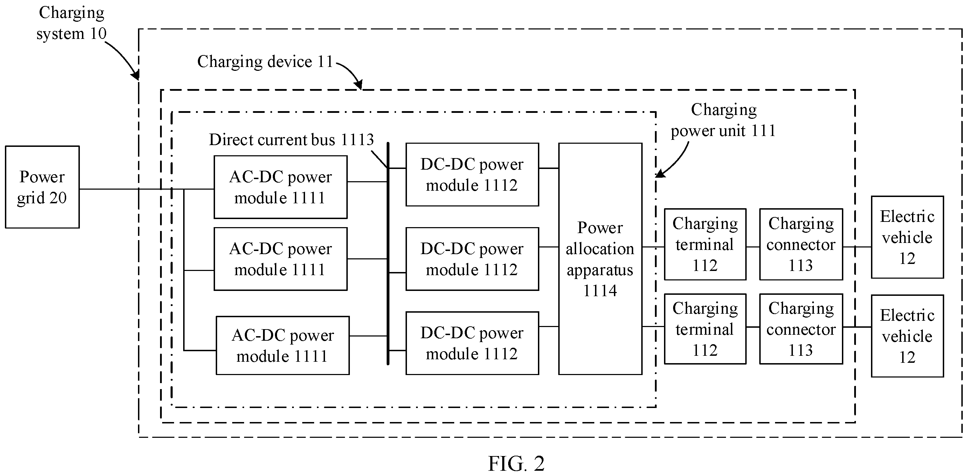

The charging device provided in embodiments of this application may be used in a charging system including an electric vehicle. In the charging system, the charging device may use electric energy from a power grid to charge the electric vehicle. The following first describes in detail the charging system provided in embodiments of this application with reference to FIG. 1 and FIG. 2.

FIG. 1 is a diagram of a structure of a charging system 10 according to an embodiment of this application. FIG. 2 is a diagram of a connection structure of the charging system 10 shown in FIG. 1.

With reference to FIG. 1 and FIG. 2, the charging system 10 includes a charging device 11 and an electric vehicle 12. The charging device 11 includes a charging power unit 111, at least one charging terminal 112, and at least one charging connector 113. In other words, the charging device 11 may be a split charging device. The charging power unit 111 includes a plurality of AC-DC power modules 1111, a plurality of DC-DC power modules 1112, a direct current bus 1113, a power allocation apparatus 1114, and at least one charging interface. The plurality of AC-DC power modules 1111 are connected in parallel between an external power grid 20 and the direct current bus 1113. Inputs of the plurality of DC-DC power modules 1112 are electrically connected to the direct current bus 1113, and outputs of the plurality of DC-DC power modules 1112 are electrically connected to inputs of the power allocation apparatus 1114. An output of the power allocation apparatus 1114 is electrically connected to the at least one charging interface. During specific implementation, each charging interface may be electrically connected to one charging terminal 112, and each charging terminal 112 is electrically connected to the at least one charging connector 113. The plurality of AC-DC power modules 1111 are configured to: receive an alternating current from the external power grid 20, convert the alternating current into a direct current, and output the direct current to the direct current bus 1113. The plurality of DC-DC power modules 1112 are configured to: obtain the direct current from the direct current bus 1113, convert the obtained direct current into a direct current applicable to the electric vehicle 12, and then transmit the direct current to the power allocation apparatus 1114. The power allocation apparatus 1114 is configured to: dynamically allocate, based on charging power actually required by the electric vehicle 12, the direct current output by the plurality of DC-DC power modules 1112, and transmit allocated charging power to the electric vehicle 12 via the charging connector 113 connected to the charging terminal 112, to charge the electric vehicle 12.

The charging terminal 112 outputs the received direct current to the electric vehicle 12 via the electrically connected charging connector 113, to charge the electric vehicle 12. For example, the charging terminal 112 includes a casing, a human-machine interaction interface, a charging control unit, a metering and billing unit, and the like, and is configured to: perform information exchange, energy transmission, metering and billing, and the like with the electric vehicle 12.

The electric vehicle 12 is a means of transportation driven by electric energy. The electric vehicle 12 may be a pure electric vehicle (pure electric vehicle/battery electric vehicle, pure EV/battery EV), a hybrid electric vehicle (hybrid electric vehicle, HEV), a range extended electric vehicle (range extended electric vehicle, REEV), a plug-in hybrid electric vehicle (plug-in hybrid electric vehicle, PHEV), or the like.

It should be understood that this embodiment of this application is described by using an example in which the charging device 11 is a split charging device. In some other embodiments, the charging device 11 may alternatively be an integrated charging device. Specifically, in the charging device 11, the human-machine interaction interface, the charging control unit, the metering and billing unit, and the like may be directly disposed in the charging power unit 111, so that the charging device 11 may not include the charging terminal 112, but includes the charging power unit 111 and the at least one charging connector 113 electrically connected to the charging power unit 111.

It should be further understood that this embodiment of this application is described by using an example in which the charging device 11 includes the AC-DC power module 1111 and the DC-DC power module 1112. In some other embodiments, the charging device 11 may include only the AC-DC power module 1111, and does not include the DC-DC power module 1112.

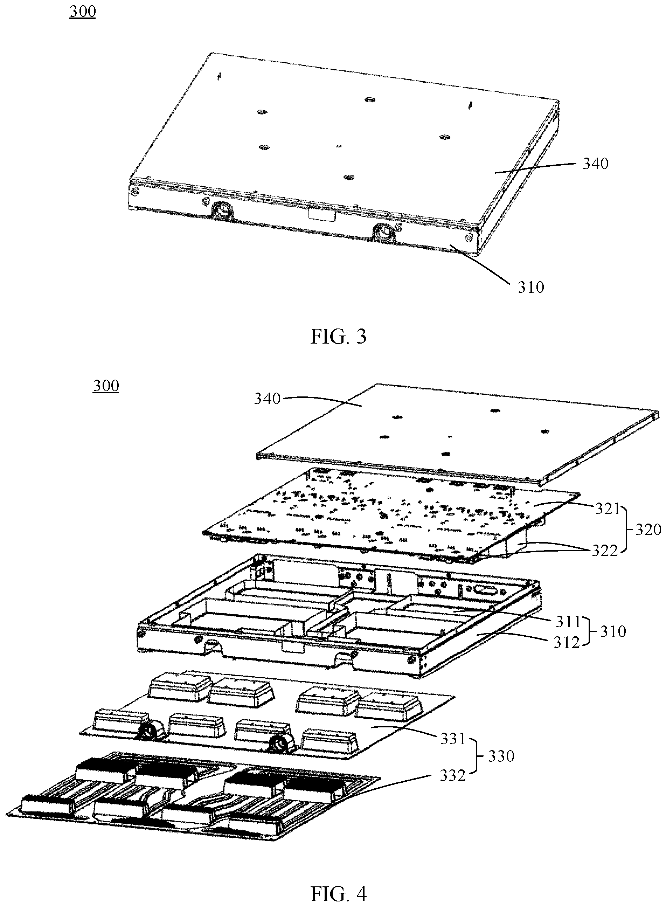

The following describes in detail a specific structure of a power module provided in embodiments of this application with reference to FIG. 3 to FIG. 9.

FIG. 3 is a diagram of a three-dimensional structure of a power module 300 according to an embodiment of this application. FIG. 4 is a schematic exploded view of the power module 300 shown in FIG. 3. It should be understood that, in this embodiment of this application, the power module 300 may be the AC-DC power module 1111 shown in FIG. 2, or the DC-DC power module 1112 shown in FIG. 2.

With reference to FIG. 3 and FIG. 4, the power module 300 includes a bottom housing 310, a circuit board assembly 320, and a liquid cooling plate assembly 330.

The bottom housing 310 has accommodation space, the circuit board assembly 320 is located in the accommodation space, and the liquid cooling plate assembly 330 is located outside the accommodation space. That is, the circuit board assembly 320 is fastened in the bottom housing 310, and the liquid cooling plate assembly 330 is fastened outside the bottom housing 310. The circuit board assembly 320 is configured to convert a received alternating current into a direct current, or the circuit board assembly 320 is configured to perform voltage conversion on a received direct current, for example, perform boosting and/or bucking conversion on the received direct current. The liquid cooling plate assembly 330 is configured to be thermally connected to the circuit board assembly 320 through the bottom housing 310.

In this way, a cooling medium circulating in the liquid cooling plate assembly 330 can exchange heat with the circuit board assembly 320 through the bottom housing 310, to take away heat generated by the circuit board assembly 320, thereby implementing liquid cooling heat dissipation for the circuit board assembly 320. Compared with a common air cooling heat dissipation manner, the liquid cooling heat dissipation manner has higher heat dissipation efficiency, so that heat dissipation effect on the circuit board assembly 320 can be improved, and a heat dissipation requirement of the circuit board assembly 320 during high-power operation can be met.

In addition, in the foregoing embodiment, the bottom housing 310 may be used as a casing of the power module 300 to protect the circuit board assembly 320, and may also be used as an isolation structure between the circuit board assembly 320 and the liquid cooling plate assembly 330 to implement water and electricity isolation between the circuit board assembly 320 and the liquid cooling plate assembly 330. This can avoid impact of cooling medium leakage in the liquid cooling plate assembly 330 on the circuit board assembly 320, to ensure safety and stability of liquid cooling heat dissipation performed by the liquid cooling plate assembly 330 on the circuit board assembly 320. Moreover, the power module 300 implements water and electricity isolation between the circuit board assembly 320 and the liquid cooling plate assembly 330 without separate disposing of an isolation structure, thereby reducing use of parts and components in the power module 300 and reducing heat dissipation costs of the power module 300. The following specifically describes structures of the power module 300 mentioned above with reference to the accompanying drawings.

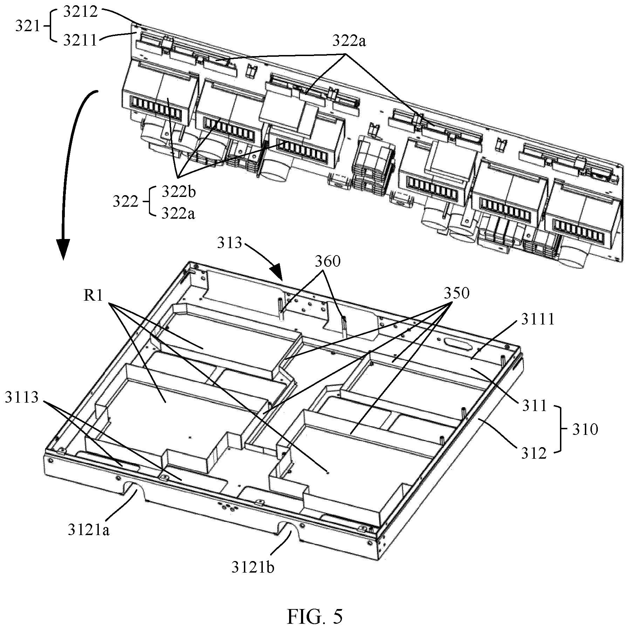

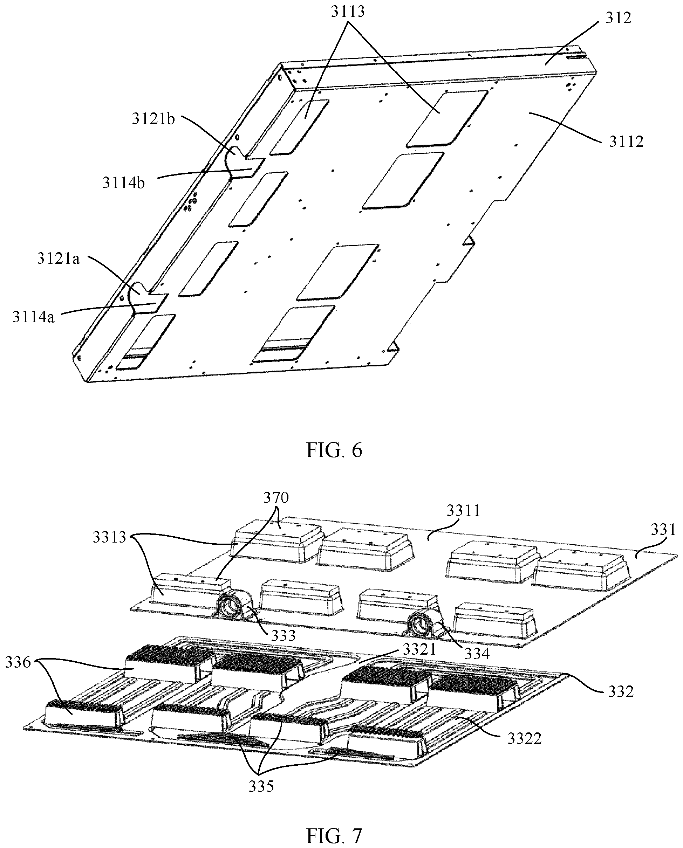

FIG. 5 is a diagram of an assembling structure of a bottom housing 310 and a circuit board assembly 320 according to an embodiment of this application. FIG. 6 is a diagram of a structure of the bottom housing 310 shown in FIG. 5 in another direction.

In some embodiments, with reference to FIG. 3 to FIG. 6, the bottom housing 310 includes a bottom plate 311 and a surrounding plate 312, and the bottom plate 311 includes a first bottom plate surface 3111 and a second bottom plate surface 3112 that are disposed opposite to each other. The first bottom plate surface 3111 is configured to fasten one end of the surrounding plate 312, so that the first bottom plate surface 3111 and the surrounding plate 312 form the accommodation space of the bottom housing 310 through enclosing, and the other end of the surrounding plate 312 forms an opening 313. That is, the bottom housing 310 is in the shape of a groove. An overall shape of the groove may be, for example, a cuboid, a square, or a cylinder.

During specific implementation, the circuit board assembly 320 may be installed in the accommodation space of the bottom housing 310 through the opening 313. In an example, with reference to FIG. 3 to FIG. 5, the power module 300 further includes a cover plate 340. The cover plate 340 covers the opening 313, and is used to open or close the opening 313. The cover plate 340 and the opening 313 may be a detachable connection structure. For example, the cover plate 340 may be fastened to the surrounding plate 312 by using a bolt or a screw.

In addition, the second bottom plate surface 3112 is configured to be fastened and thermally connected to the liquid cooling plate assembly 330, so that the liquid cooling plate assembly 330 may be thermally connected to the circuit board assembly 320 in the bottom housing 310 through the bottom plate 311. A specific manner in which the liquid cooling plate assembly 330 is thermally connected to the circuit board assembly 320 is described below, and details are not described herein.

For example, the bottom housing 310 may be fabricated of a sheet metal material by using a stamping molding process. Specifically, the bottom plate 311 and the surrounding plate 312 may be integrally formed of the sheet metal material by using the stamping molding process. The sheet metal material may be, for example, a steel plate, a stainless steel plate, an aluminum alloy plate, or a copper alloy plate.

It should be understood that, if the bottom housing 310 is fabricated by using a die-casting molding process, costs of the die-casting molding process are relatively high. In addition, a thermal conductivity coefficient of a material used in the die-casting molding process is relatively low, and pores are likely to be generated in a bottom housing 310 formed by die-casting molding, which easily causes relatively poor thermal conductivity of the bottom housing 310. Consequently, a heat conduction speed of the liquid cooling plate assembly 330 for heat exchange with the circuit board assembly 320 through the bottom housing 310 is relatively low, and heat dissipation efficiency of the circuit board assembly 320 is relatively low.

Moreover, to meet a requirement for increasing power of the power module 300, a size and an arrangement manner of a power device in the circuit board assembly 320 are continuously adjusted. Correspondingly, to accommodate the circuit board assembly 320, a structure of the bottom housing 310 also needs to be adjusted accordingly. However, hardness and brittleness of the bottom housing 310 formed by die-casting molding are relatively high, and a structure of a die-casting die usually needs to be adjusted first for adjustment of a structure of the bottom housing 310 formed by die-casting molding. This results in relatively high processing difficulty and high costs in adjusting the structure of the bottom housing 310.

Therefore, in this embodiment of this application, the bottom housing 310 is fabricated of the sheet metal material by using the stamping molding process. The sheet metal material has relatively high thermal conductivity, and pores are not likely to be generated in the bottom housing 310 formed by stamping molding, which helps the bottom housing 310 achieve good thermal conductivity. In this way, heat generated by the circuit board assembly 320 during operation can be quickly transferred through the bottom housing 310 to the liquid cooling plate assembly 330 outside the bottom housing 310, to implement liquid cooling heat dissipation for the circuit board assembly 320, and can also be directly transferred to the outside of the bottom housing 310 through the bottom housing 310, to implement natural heat dissipation for the circuit board assembly 320. In this case, heat dissipation efficiency of the circuit board assembly 320 is improved.

Moreover, in comparison with the die-casting molding process, the die-casting die may not be used in the stamping molding process of the sheet metal material, so that the process is simpler and costs are lower. In addition, the bottom housing 310 fabricated of the sheet metal material by stamping molding has relatively high toughness. Therefore, in comparison with the die-casting molding process, the bottom housing 310 fabricated of the sheet metal material by using the stamping molding process better helps reduce processing difficulty of adjusting the structure of the bottom housing 310, and reduce processing costs.

With reference to FIG. 4 and FIG. 5, in some embodiments, the circuit board assembly 320 includes a circuit board 321 and a plurality of power devices 322. The circuit board 321 and the bottom plate 311 are disposed opposite to each other. The circuit board 321 includes a first circuit board surface 3211 and a second circuit board surface 3212 that are disposed opposite to each other. The first circuit board surface 3211 faces the bottom plate 311, and the second circuit board surface 3212 faces away from the bottom plate 311. The plurality of power devices 322 are fastened to the first circuit board surface 3211.

During specific implementation, the circuit board 321 may be installed in the bottom housing 310 in an inverted manner, so that the plurality of power devices 322 may be located between the circuit board 321 and the bottom plate 311, and the plurality of power devices 322 are thermally connected through the bottom plate 311 to the liquid cooling plate assembly 330 fastened outside the bottom plate 311. In other words, in this embodiment of this application, there is spacing between the first circuit board surface 3211 of the circuit board 321 and the bottom plate 311, to facilitate arrangement of the plurality of power devices 322.

In this embodiment of this application, the circuit board 321 may be a printed circuit board (printed circuit board, PCB), a ceramic circuit board, an aluminum oxide ceramic circuit board, an aluminum nitride ceramic circuit board, a wiring board, an aluminum substrate, a high-frequency board, an impedance board, or the like. For ease of description and understanding, this embodiment of this application is described by using an example in which the circuit board 321 is a printed circuit board.

In some embodiments, as shown in FIG. 5, the plurality of power devices 322 may include a plurality of first power devices 322a and a plurality of second power devices 322b. The plurality of first power devices 322a may include a power switch transistor. The plurality of second power devices 322b may include devices having heat consumption, such as a capacitor, an inductor, and a transformer. A height of the first power device 322a is less than a height of the second power device 322b.

For example, the power switch transistor may be a plurality of types of power switch transistors, such as a metal-oxide semiconductor field-effect transistor (metal-oxide semiconductor field-effect transistor, MOSFET), a bipolar junction transistor (bipolar junction transistor, BJT), an insulated gate bipolar transistor (insulated gate bipolar transistor, IGBT), and a silicon carbide (SiC) transistor.

During specific implementation, the power switch transistor, the inductor, the capacitor, and the transformer are electrically connected by using the circuit board 321, to form an AC-DC conversion circuit or a DC-DC conversion circuit. The AC-DC conversion circuit is configured to convert an alternating current into a direct current, and the DC-DC conversion circuit is configured to perform voltage conversion on a direct current.

In some embodiments, still with reference to FIG. 4 and FIG. 5, to enable the plurality of second power devices 322b with relatively high heights to be thermally connected to the liquid cooling plate assembly 330 through the bottom plate 311, the power module 300 further includes a partition plate 350. The partition plate 350 is located in the bottom housing 310, and is configured to divide the accommodation space of the bottom housing 310 into a plurality of accommodating cavities R1. The plurality of second power devices 322b are located in the plurality of accommodating cavities R1. For example, one second power device 322b is disposed in one accommodating cavity R1, or the plurality of second power devices 322b are disposed in a same accommodating cavity R1.

The second power device 322b located in the accommodating cavity R1 is thermally connected to an inner side wall of the accommodating cavity R1 and the bottom housing 310. Specifically, one end of the partition plate 350 is fastened and thermally connected to the first bottom plate surface 3111 that is of the bottom plate 311 and that faces the circuit board 321, and the other end of the partition plate 350 extends toward the circuit board 321, so that the partition plate 350 divides the accommodation space formed by the bottom plate 311 and the surrounding plate 312 through enclosing into the plurality of accommodating cavities R1.

Therefore, the partition plate 350 forms a side wall of the accommodating cavity R1, and the bottom plate 311 forms a bottom of the accommodating cavity R1. One end that is of the second power device 322b and that faces the bottom plate 311 is thermally connected to the first bottom plate surface 3111 of the bottom plate 311. An outer circumferential surface of the second power device 322b is thermally connected to the inner side wall of the accommodating cavity R1, that is, is thermally connected to the partition plate 350.

In this way, heat generated by the second power device 322b during operation not only can be directly transferred to the bottom plate 311 through the end that is of the second power device 322b and that faces the bottom plate 311, but also can be first transferred to the partition plate 350 through the outer circumferential surface of the second power device 322b, and then transferred to the bottom plate 311. Then, the bottom plate 311 may transfer absorbed heat to the liquid cooling plate assembly 330 through the second bottom plate surface 3112 that faces away from the circuit board 321, so that the liquid cooling plate assembly 330 implements liquid cooling heat dissipation for the second power device 322b. In this way, efficiency in transferring the heat of the second power device 322b to the liquid cooling plate assembly 330 is improved, and heat dissipation effect on the power module 300 is improved.

It should be understood that, because shapes and/or sizes of the plurality of second power devices 322b are different, shapes and/or sizes of the plurality of accommodating cavities R1 may be different. During specific implementation, a shape of the inner side wall of the accommodating cavity R1 matches a shape of the outer circumferential surface of the second power device 322b located in the accommodating cavity R1, so that the second power device 322b is installed in the accommodating cavity R1, and the outer circumferential surface of the second power device 322b is better attached to the inner side wall of the accommodating cavity R1. In this way, the outer circumferential surface of the second power device 322b may have a large contact area with the inner side wall of the accommodating cavity R1, thereby improving efficiency in transferring heat of the second power device 322b to the liquid cooling plate assembly 330.

It should be further understood that, in this embodiment of this application, the second power device 322b may be in direct thermal contact or indirect thermal contact with the first bottom plate surface 3111 of the bottom plate 311, and with the inner side wall of the accommodation cavity R1.

For example, in some embodiments, each accommodating cavity R1 accommodates a thermal conductive adhesive, and the second power device 322b is buried in the thermal conductive adhesive. The end that is of the second power device 322b and that faces the bottom plate 311 is thermally connected to the first bottom plate surface 3111 through the thermal conductive adhesive. The outer circumferential surface of the second power device 322b is thermally connected to the inner side wall of the accommodating cavity R1 through the thermal conductive adhesive. The thermal conductive adhesive may be, for example, a thermal conductive gel or a potting adhesive.

It should be noted that, that the second power device 322b is buried in the thermal conductive adhesive may mean that at least a part of the second power device 322b is covered by the thermal conductive adhesive.

It should be understood that, during specific implementation, it is difficult to implement close contact between the surface that is of the second power device 322b and that faces the bottom plate 311 and the first bottom plate surface 3111, and close contact between the outer circumferential surface of the second power device 322b and the inner side wall of the accommodating cavity R1. As a result, it is likely that a gap exists between the surface that is of the second power device 322b and that faces the bottom plate 311 and the first bottom plate surface 3111, and between the outer circumferential surface of the second power device 322b and the inner side wall of the accommodating cavity R1. Therefore, efficiency in transferring heat of the second power device 322b to the bottom plate 311 and the inner side surface of the accommodating cavity R1 is affected.

Therefore, in this embodiment of this application, the accommodating cavity R1 is filled with the thermal conductive adhesive, so that the gap between the surface that is of the second power device 322b and that faces the bottom plate 311 and the first bottom plate surface 3111, and the gap between the outer circumferential surface of the second power device 322b and the inner side wall of the accommodating cavity R1 are filled with the thermal conductive adhesive. In this way, the second power device 322b is in close contact with the first bottom plate surface 3111, and the second power device 322b is in close contact with the inner side wall of the accommodating cavity R1. This can improve efficiency in transferring heat of the second power device 322b to the bottom plate 311, thereby improving heat dissipation efficiency of the power module 300.

In some embodiments, with reference to FIG. 4 and FIG. 5, when the other end of the partition plate 350 extends toward the circuit board 321, the other end of the partition plate 350 is not in contact with the circuit board 321. In other words, there is a gap between the other end of the partition plate 350 and the first circuit board surface 3211 that is of the circuit board 321 and that faces the bottom plate 311. In this way, space on the first circuit board surface 3211 can be prevented from being occupied due to contact between the other end of the partition plate 350 and the first circuit board surface 3211, thereby facilitating arrangement of the plurality of power devices 322 in the power module 300 on the first circuit board surface 3211.

In some embodiments, the partition plate 350 may be fabricated of the sheet metal material by using the stamping molding process, or the partition plate 350 may be fabricated by using a plastic molding process. Compared with a process of fabricating the partition plate 350 by using a profile molding process, the processes of fabricating the partition plate 350 are simpler, processing difficulty is smaller, and costs are lower.

For example, when both the partition plate 350 and the bottom plate 311 are fabricated of the sheet metal material by using the stamping molding process, one end of the partition plate 350 and the first bottom plate surface 3111 of the bottom plate 311 may be fastened by welding.

In some embodiments, as shown in FIG. 5, in order to fasten the circuit board assembly 320 in the bottom housing 310, the power module 300 further includes a fastener 360. One end of the fastener 360 is fastened to the circuit board 321, and the other end of the fastener 360 is fastened to the bottom plate 311. That is, the fastener 360 extends in an arrangement direction of the circuit board 321 and the plurality of power devices 322. The fastener 360 may be, for example, a press-fit stud or a press-fit screw.

In this embodiment of this application, the circuit board assembly 320 is fastened in the bottom housing 310 by using the fastener 360. In other words, the bottom housing 310 is also configured to support and fasten the circuit board assembly 320. In this way, in the power module 300, a support structure does not need to be separately disposed for the circuit board assembly 320. Further, a structure of the power module 300 is simplified, and use of parts and components in the power module 300 is reduced, thereby reducing costs of the power module 300.

Furthermore, in some embodiments, projections of the fastener 360 and the partition plate 350 do not overlap in the arrangement direction of the circuit board 321 and the plurality of power devices 322. To be specific, the other end of the fastener 360 is not installed on the partition plate 350, but is directly installed on the bottom plate 311.

It should be understood that, when the other end of the fastener 360 is installed on the other end that is of the partition plate 350 and that extends toward the circuit board 321, a surface of the other end of the partition plate 350 usually needs to be machined, so that a surface difference of the surface meets an installation requirement of the fastener 360. As a result, processing difficulty and processing costs of the partition plate 350 are high. Therefore, in this embodiment of this application, the fastener 360 and the partition plate 350 are separately installed, which helps reduce the processing difficulty and the processing costs of the partition plate 350.

The foregoing describes a specific manner in which the second power device 322b with a relatively high height is thermally connected to the liquid cooling plate assembly 330 through the bottom plate 311. The following describes, still with reference to the accompanying drawings, a specific manner in which the first power device 322a with a relatively low height is thermally connected to the liquid cooling plate assembly 330 through the bottom plate 311, and a specific structure of the liquid cooling plate assembly 330.

FIG. 7 is a diagram of a structure of a liquid cooling plate assembly 330 according to an embodiment of this application. In some embodiments, with reference to FIG. 4 to FIG. 7, the liquid cooling plate assembly 330 is fastened to the second bottom plate surface 3112 of the bottom plate 311, that is, the liquid cooling plate assembly 330 is located on a side that is of the plurality of power devices 322 and that is away from the circuit board 321. The liquid cooling plate assembly 330 includes a liquid cooling top plate 331 and a liquid cooling bottom plate 332. The liquid cooling top plate 331 and the liquid cooling bottom plate 332 are sequentially arranged in a direction from the circuit board 321 to the plurality of power devices 322, that is, in a direction from the circuit board 321 to the bottom plate 311.

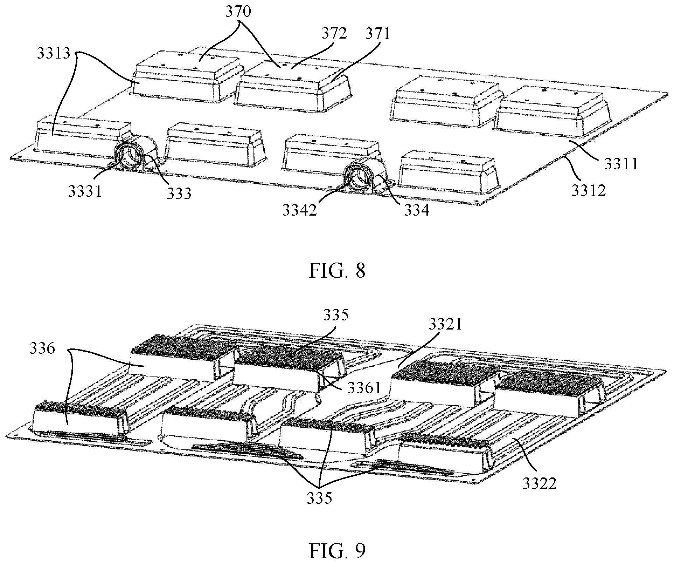

FIG. 8 is a diagram of a structure of the liquid cooling top plate 331 shown in FIG. 7, and FIG. 9 is a diagram of a structure of the liquid cooling bottom plate 332 shown in FIG. 7.

With reference to FIG. 5 to FIG. 9, in some embodiments, a first liquid cooling top plate surface 3311 that is of the liquid cooling top plate 331 and that faces the circuit board 321 is fastened and thermally connected to the second bottom plate surface 3112 that is of the bottom plate 311 and that is away from the circuit board 321. A second liquid cooling top plate surface 3312 that is of the liquid cooling top plate 331 and that is away from the circuit board 321 is fastened to the liquid cooling bottom plate 332. A liquid cooling channel is formed between the liquid cooling top plate 331 and the liquid cooling bottom plate 332, and the liquid cooling channel is configured to accommodate a cooling medium.

For example, the first liquid cooling bottom plate surface 3321 that is of the liquid cooling bottom plate 332 and that faces the circuit board 321 is recessed in a direction away from the circuit board 321, to form a plurality of flow channels 3322. The liquid cooling top plate 331 covers the first liquid cooling bottom plate surface 3321 of the liquid cooling bottom plate 332, to seal the plurality of flow channels 3322, so that a liquid cooling channel is formed between the liquid cooling top plate 331 and the liquid cooling bottom plate 332.

In this way, the heat generated by the second power device 322b in the accommodating cavity R1 during operation may be transferred to the liquid cooling top plate 331 through the second bottom plate surface 3112 of the bottom plate 311, and then transferred to the cooling medium in the liquid cooling channel through the liquid cooling top plate 331. Therefore, the cooling medium in the liquid cooling channel may exchange heat with the second power device 322b, to take away the heat generated by the second power device 322b, thereby implementing liquid cooling heat dissipation for the second power device 322b.

In some embodiments, the first liquid cooling top plate surface 3311 of the liquid cooling top plate 331 may be fastened to the second bottom plate surface 3112 of the bottom plate 311 by welding. The second liquid cooling top plate surface 3312 of the liquid cooling top plate 331 may be fastened to the first liquid cooling bottom plate surface 3321 of the liquid cooling bottom plate 332 by welding.

In the foregoing embodiment, a weld seam fastening the liquid cooling top plate 331 to the bottom housing 310 and a weld seam for implementing sealing on the flow channel between the liquid cooling top plate 331 and the liquid cooling bottom plate 332 are both located outside the bottom housing 310. In this case, the bottom housing 310 can effectively isolate the circuit board assembly 320 in the bottom housing 310 from the liquid cooling channel outside the bottom housing 310, thereby implementing water and electricity isolation between the circuit board assembly 320 and the liquid cooling plate assembly 330.

In addition, in comparison with mechanical fastening performed between the liquid cooling top plate 331 and the bottom housing 310 by using a fastener such as a screw, in this embodiment of this application, the liquid cooling top plate 331 and the bottom housing 310 are fastened by welding, so that use of parts and components in the power module 300 can be reduced, thereby reducing heat dissipation costs of the power module 300.

In some embodiments, the liquid cooling top plate 331 and the liquid cooling bottom plate 332 may be separately fabricated of the sheet metal material by using the stamping molding process. The sheet metal material may be, for example, a steel plate, a stainless steel plate, aluminum alloy, or copper alloy.

In the foregoing embodiment, in comparison with a liquid cooling top plate 331 and a liquid cooling bottom plate 332 that are fabricated by using the die-casting molding process, the liquid cooling top plate 331 and the liquid cooling bottom plate 332 fabricated of the sheet metal material by using the stamping molding process can achieve good thermal conductivity. In this way, the heat generated by the second power device 322b may be transferred to the cooling medium in the liquid cooling channel relatively quickly through the liquid cooling top plate 331, thereby improving heat dissipation efficiency of the circuit board assembly 320. Moreover, compared with the die-casting molding process, the stamping molding process of the sheet metal material is simpler and costs are lower.

For example, the liquid cooling top plate 331, the liquid cooling bottom plate 332, and the bottom housing 310 may be fabricated of a same sheet metal material by using the stamping molding process, to enhance firmness of welding between the liquid cooling top plate 331 and the liquid cooling bottom plate 332 and between the liquid cooling top plate 331 and the bottom housing 310.

Further, in some embodiments, with reference to FIG. 7 and FIG. 8, the liquid cooling plate assembly 330 further includes a liquid inlet connector 333 and a liquid outlet connector 334. The liquid inlet connector 333 and the liquid outlet connector 334 are fastened to the first liquid cooling top plate surface 3311 that is of the liquid cooling top plate 331 and that faces the circuit board 321, and the liquid inlet connector 333 and the liquid outlet connector 334 are separately connected to the liquid cooling channel. The liquid inlet connector 333 allows the cooling medium to flow into the liquid cooling channel, and the liquid outlet connector 334 allows the cooling medium in the liquid cooling channel to flow out of the liquid cooling channel. In this way, the cooling medium circulates in the liquid cooling channel.

During specific implementation, in an example, the liquid cooling top plate 331 includes two mounting holes (not shown in the figure). The two mounting holes pass through the liquid cooling top plate 331 in the arrangement direction of the circuit board 321 and the plurality of power devices 322. The liquid inlet connector 333 includes a first liquid inlet 3331 and a first liquid outlet (not shown in the figure) that are connected to each other. The liquid outlet connector 334 includes a second liquid inlet (not shown in the figure) and a second liquid outlet 3342 that are connected to each other. The first liquid inlet 3331 of the liquid inlet connector 333 is configured to connect an output of an external cooling system, and the first liquid outlet of the liquid inlet connector 333 is connected to the liquid cooling channel through one mounting hole in the liquid cooling top plate 331, so that a cooling medium in the external cooling system flows into the liquid cooling channel through the liquid inlet connector 333.

Similarly, the second liquid inlet of the liquid outlet connector 334 is connected to the liquid cooling channel through the other mounting hole in the liquid cooling top plate 331, and the second liquid outlet 3342 of the liquid outlet connector 334 is configured to connect to a liquid inlet of the external cooling system, so that the cooling medium in the liquid cooling channel flows out of the liquid cooling channel through the liquid outlet connector 334 and flows into the external cooling system. In this way, the cooling medium circulates between the external cooling system and the liquid cooling channel.

It should be understood that the external cooling system may be a cooling system that is located outside the power module 300, can provide a cooling medium for the liquid cooling channel, and can reduce a temperature of the cooling medium provided for the liquid cooling channel.

In this embodiment of this application, after the heat generated by the second power device 322b is transferred to the cooling medium in the liquid cooling channel, the cooling medium that carries the heat may flow out to the external cooling system through the liquid outlet connector 334. The external cooling system may cool the cooling medium that carries the heat, and the cooled cooling medium flows into the liquid cooling channel again through the liquid inlet connector 333. In this way, the cooling medium is cyclically used.

For example, the liquid inlet connector 333 and the liquid outlet connector 334 each may be of a water nozzle structure. In some embodiments, with reference to FIG. 5 to FIG. 8, the bottom plate 311 includes a bottom plate mounting hole 3114a and a bottom plate mounting hole 3114b. The surrounding plate 312 includes a surrounding plate mounting hole 3121a and a surrounding plate mounting hole 3121b. The first liquid inlet 3331 of the liquid inlet connector 333 extends into the bottom housing 310 through the bottom plate mounting hole 3114a, and the first liquid inlet 3331 is connected to the surrounding plate mounting hole 3121a, so that the first liquid inlet 3331 is connected to the external cooling system through the surrounding plate mounting hole 3121a.

Similarly, the second liquid outlet 3342 of the liquid outlet connector 334 extends into the bottom housing 310 through the bottom plate mounting hole 3114b, and the second liquid outlet 3342 is connected to the surrounding plate mounting hole 3121b, so that the second liquid outlet 3342 is connected to the external cooling system through the surrounding plate mounting hole 3121b.

In some examples, in the arrangement direction of the circuit board 321 and the plurality of power devices 322, a projection of the liquid inlet connector 333 and a projection of the liquid outlet connector 334 are located in a projection of the bottom housing 310. To be specific, in a direction perpendicular to an arrangement direction of the circuit board 321 and the bottom plate 311, the liquid inlet connector 333 and the liquid outlet connector 334 are not exposed on the bottom housing 310 through the surrounding plate mounting hole 3121a and the surrounding plate mounting hole 3121b. This is conducive to a normalized design of an overall structure of the power module 300.

In some other examples, in the arrangement direction of the circuit board 321 and the plurality of power devices 322, projections of the first liquid inlet 3331 of the liquid inlet connector 333 and the second liquid outlet 3342 of the liquid outlet connector 334 are both located outside a projection of the bottom housing 310. That is, in a direction perpendicular to the circuit board 321 and the bottom plate 311, the first liquid inlet 3331 of the liquid inlet connector 333 is exposed to the bottom housing 310 through the surrounding plate mounting hole 3121a, and the second liquid outlet 3342 of the liquid outlet connector 334 is exposed to the bottom housing 310 through the surrounding plate mounting hole 3121b. This allows the first liquid inlet 3331 and the second liquid outlet 3342 to be easily assembled with pipes respectively, so that the first liquid inlet 3331 and the second liquid outlet 3342 are connected to the external cooling system by using the pipes.

With reference to the specific structure of the liquid cooling plate assembly 330, the following describes the specific manner in which the first power device 322a with a relatively low height is thermally connected to the liquid cooling plate assembly 330 through the bottom plate 311.

In some embodiments, with reference to FIG. 5 to FIG. 8, because distances between the circuit board 321 and the liquid cooling top plate 331 are approximately the same, and the height of the first power device 322a is less than the height of the second power device 322b, to implement thermal connection between the first power device 322a and the liquid cooling top plate 331 and between the second power device 322b and the liquid cooling top plate 331, a position that is on the liquid cooling top plate 331 and that corresponds to the first power device 322a is recessed toward the circuit board 321 to form a groove structure 3313. An opening of the groove structure 3313 faces the liquid cooling bottom plate 332, and a groove bottom of the groove structure 3313 extends into the bottom housing 310 and is thermally connected to one end that is of the first power device 322a and that faces the liquid cooling top plate 331. Specifically, a through hole 3113 is provided at a position that is on the bottom plate 311 and that corresponds to the first power device 322a. The groove bottom of the groove structure 3313 extends into the bottom housing 310 through the through hole 3113 in the bottom plate 311, so as to be thermally connected to the end that is of the first power device 322a and that faces the liquid cooling top plate 331.

In this way, heat generated by the first power device 322a during operation is transferred to the groove structure 3313 of the liquid cooling top plate 331 through the end that is of the first power device 322a and that faces the liquid cooling top plate 331, and then transferred to the cooling medium in the liquid cooling channel, to implement liquid cooling heat dissipation for the first power device 322a, thereby ensuring heat dissipation effect on the first power device 322a.

Further, in some embodiments, with reference to FIG. 7 and FIG. 8, the power module 300 further includes a thermal conductor 370. The groove bottom of the groove structure 3313 is thermally connected through the thermal conductor 370 to the end that is of the first power device 322a and that faces the liquid cooling top plate 331. The thermal conductor 370 may be, for example, an aluminum block.

For example, the thermal conductor 370 includes a first thermal conductor surface 371 and a second thermal conductor surface 372 that are provided opposite to each other. The first thermal conductor surface 371 is configured to be thermally connected to the groove bottom of the groove structure 3313. The second thermal conductor surface 372 is configured to be thermally connected to the surface that is of the first power device 322a and that faces the liquid cooling top plate 331. The first thermal conductor surface 371 may, for example, be fastened and thermally connected to the groove bottom of the groove structure 3313 by welding.

It should be understood that, during specific implementation, it may be difficult for the surface that is of the first power device 322a and that faces the liquid cooling top plate 331 to be in close contact with an outer surface of the groove bottom of the groove structure 3313 due to a shape difference. As a result, a contact area between the first power device 322a and the groove structure 3313 is relatively small, thereby affecting efficiency in transferring heat of the first power device 322a to the liquid cooling top plate 331.

In this embodiment of this application, the end that is of the first power device 322a and that faces the liquid cooling top plate 331 is thermally connected to the groove bottom of the groove structure 3313 through the thermal conductor 370. A shape of the first thermal conductor surface 371 of the thermal conductor 370 is designed to match the outer surface of the groove bottom of the groove structure 3313, and a shape of the second thermal conductor surface 372 of the thermal conductor 370 is designed to match the surface that is of the first power device 322a and that faces the liquid cooling top plate 331, so that the surface that is of the first power device 322a and that faces the liquid cooling top plate 331 and the outer surface of the groove bottom of the groove structure 3313 are in close contact with the surfaces of the thermal conductor 370 respectively. In this way, the first power device 322a may have a relatively large contact area with the groove bottom of the groove structure 3313 by using the thermal conductor 370, thereby ensuring efficiency in transferring heat of the first power device 322a to the groove structure 3313 of the liquid cooling top plate 331.

In some embodiments, with reference to FIG. 7 and FIG. 9, the liquid cooling plate assembly 330 may further include turbulence fins 335. There are a plurality of turbulence fins 335, and the plurality of turbulence fins 335 are located in the liquid cooling channel. With reference to FIG. 4, FIG. 7, and FIG. 9, in the arrangement direction of the circuit board 321 and the plurality of power devices 322, that is, in an arrangement direction of the liquid cooling top plate 331 and the liquid cooling bottom plate 332, projections of the plurality of turbulence fins 335 overlap projections of at least some of the plurality of power devices 322. That is, the plurality of turbulence fins 335 correspond to the at least some of the plurality of power devices 322.

In this way, when the cooling medium flows in the liquid cooling channel, the turbulence fins 335 may repeatedly disturb the cooling medium, so that a local heat dissipation enhancement of the cooling medium is formed at a position that is in the liquid cooling channel and that corresponds to the power device 322, thereby improving heat dissipation efficiency of the liquid cooling plate assembly 330 for the plurality of power devices 322.

Further, in some embodiments, with reference to FIG. 4, FIG. 7, and FIG. 9, the liquid cooling plate assembly 330 further includes a boss structure 336. The boss structure 336 is fastened to the first liquid cooling bottom plate surface 3321 that is of the liquid cooling bottom plate 332 and that faces the circuit board 321, and extends toward the circuit board 321. The boss structure 336 is disposed corresponding to the groove structure 3313.

The boss structure 336 extends into the groove structure 3313 through the opening of the groove structure 3313. There is spacing between the boss structure 336 and the groove structure 3313, to form the liquid cooling channel between the liquid cooling top plate 331 and the liquid cooling bottom plate 332. The turbulence fins 335 are located in the liquid cooling channel and are fastened to an end face 3361 that is of the boss structure 336 and that faces the circuit board 321. For example, the turbulence fins 335 may be fastened, by welding, to the end face 3361 that is of the boss structure 336 and that faces the circuit board 321.

It should be understood that, because the groove structure 3313 is formed at the position that is on the liquid cooling top plate 331 and that corresponds to the first power device 322a, and a distance between the groove structure 3313 of the liquid cooling top plate 331 and the liquid cooling bottom plate 332 is relatively long, a size of a liquid cooling channel formed at the groove structure 3313 is relatively large. However, the turbulence fins 335 have a relatively poor capability of repeatedly disturbing the cooling medium in the liquid cooling channel with a relatively large size. Consequently, local heat dissipation enhancement effect of the cooling medium is deteriorated.

Therefore, in this embodiment of this application, the boss structure 336 is disposed at a position that is on the liquid cooling bottom plate 332 and that corresponds to the groove structure 3313, to reduce the distance between the groove structure 3313 of the liquid cooling top plate 331 and the liquid cooling bottom plate 332, thereby reducing the size of the liquid cooling channel formed at the groove structure 3313. This helps improve a capability of the turbulence fins 335 to repeatedly disturb the cooling medium in the liquid cooling channel at the groove structure 3313, thereby enhancing local heat dissipation enhancement effect of the cooling medium formed at a position that is in the liquid cooling channel and that corresponds to the first power device 322a, and improving heat dissipation efficiency of the liquid cooling plate assembly 330 for the first power device 322a.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A power module, wherein the power module comprises a circuit board, an integrally formed bottom housing, a cover plate, a liquid cooling top plate, and a liquid cooling bottom plate, the integrally formed bottom housing comprises a bottom plate and a surrounding plate, the bottom plate and the surrounding plate form a cavity through enclosing, the circuit board is located in the cavity, a plurality of power devices are fastened to a surface that is of the circuit board and that faces the bottom plate, and the cover plate covers an opening of the cavity;
the bottom plate, the liquid cooling top plate, and the liquid cooling bottom plate are sequentially arranged in a direction from the circuit board to the bottom plate, the bottom plate is fastened to the liquid cooling top plate by welding, and the liquid cooling top plate is fastened to the liquid cooling bottom plate by welding; and
a liquid cooling channel is formed between the liquid cooling top plate and the liquid cooling bottom plate, and the liquid cooling channel is used for cooling liquid circulation.

2. The power module according to claim 1, wherein the bottom plate comprises a first opening, a part of the liquid cooling top plate protrudes toward the circuit board through the first opening to form a first protrusion structure, and a surface that is of the first protrusion structure and that faces the circuit board is thermally connected to a first power device of the plurality of power devices.

3. The power module according to claim 2, wherein the power module further comprises a thermal conductor, the thermal conductor is fastened to the surface that is of the first protrusion structure and that faces the circuit board, and the first protrusion structure is thermally connected to the first power device through the thermal conductor.

4. The power module according to claim 2 or 3, wherein the power module further comprises a boss structure and turbulence fins, wherein
the first protrusion structure comprises a notch, the notch faces the liquid cooling bottom plate, one end of the boss structure is fastened to a surface that is of the liquid cooling bottom plate and that faces the liquid cooling top plate, the other end of the boss structure extends into the notch, and there is spacing between the boss structure and the first protrusion structure; and
the turbulence fins are located in the spacing, the turbulence fins are fastened to the boss structure by welding, and the turbulence fins are fastened to the first protrusion structure by welding.

5. The power module according to claim 2 or 3, wherein the first protrusion structure comprises a notch, the notch faces the liquid cooling bottom plate, the liquid cooling bottom plate protrudes toward the notch to form a second protrusion structure, a part of the second protrusion structure extends into the notch, and there is spacing between the second protrusion structure and the first protrusion structure; and
the power module further comprises turbulence fins, the turbulence fins are located in the spacing, the turbulence fins are fastened to the first protrusion structure by welding, and the turbulence fins are fastened to the second protrusion structure by welding.

6. The power module according to any one of claims 2 to 5, wherein the power module further comprises a partition plate, and the partition plate is located in the cavity, wherein
one end of the partition plate is connected to the bottom plate, the other end of the partition plate extends toward the circuit board, the partition plate and an area that is of the bottom plate and on which the first opening is not provided form a sub-cavity through enclosing, the sub-cavity is filled with a thermal conductive adhesive, and a part of a second power device in the plurality of power devices extends into the thermal conductive adhesive; and
a length of the second power device is greater than a length of the first power device in an arrangement direction of the circuit board and the bottom plate.

7. The power module according to claim 6, wherein the other end of the partition plate is not in contact with the circuit board.

8. The power module according to any one of claims 1 to 7, wherein the power module further comprises a columnar structure and a nut structure, and the bottom plate and the circuit board each comprise a mounting hole, wherein
one end of the columnar structure is fastened to a mounting hole of the bottom plate, the other end of the columnar structure passes through a mounting hole of the circuit board and extends out of the mounting hole of the circuit board, and threads are provided on an outer circumferential side of the other end of the columnar structure, and
the nut structure is located on a side that is of the circuit board and that is away from the bottom plate, the nut structure is sleeved on the other end of the columnar structure, a threaded groove is provided on an inner circumferential side of the nut structure, and the threaded groove is connected to the threads in a fitting manner.

9. The power module according to any one of claims 1 to 8, wherein in a direction perpendicular to the arrangement direction of the circuit board and the bottom plate, a length of the bottom plate is separately greater than a length of the liquid cooling top plate and a length of the liquid cooling bottom plate.

10. The power module according to any one of claims 1 to 9, wherein the power module further comprises a liquid inlet pipe and a liquid outlet pipe, an outer circumferential side of the surrounding plate comprises two second openings, and the liquid cooling top plate comprises two third openings, wherein
a liquid inlet of the liquid inlet pipe faces one second opening, to communicate with the outside of the cavity through the second opening, and a liquid outlet of the liquid inlet pipe extends into the liquid cooling channel through one third opening; and
a liquid outlet of the liquid outlet pipe faces the other second opening, to communicate with the outside of the cavity through the other second opening, and a liquid inlet of the liquid outlet pipe extends into the liquid cooling channel through the other third opening.

11. The power module according to any one of claims 1 to 10, wherein in the arrangement direction of the circuit board and the bottom plate, a thickness of any one of the integrally formed bottom housing, the liquid cooling top plate, and the liquid cooling bottom plate is greater than or equal to 0.8 mm and less than or equal to 2.5 mm.

12. The power module according to any one of claims 1 to 11, wherein the integrally formed bottom housing, the liquid cooling top plate, and the liquid cooling bottom plate are separately fabricated by using a sheet metal process.

13. A charging device, wherein the charging device comprises the power module according to any one of claims 1 to 12 and a charging connector, and the charging connector is configured to transfer, to an electric vehicle, electric energy output by the power module.
